# EUROPEAN PATENT APPLICATION

(11) **EP 2 896 742 A1**
(43) Date of publication of application: **22.07.2015**
(21) Application number: 14151981.9
(22) Date of filing: 21.01.2014
(51) Int. Cl.: D06P 3/80, C03C 25/10, C03C 25/22, C03C 25/60, D06P 5/00, D06P 3/24, D06Q 1/00, D06B 11/00, C23C 18/16

(54) **Manufacturing method of a colored high-strength fiber and a colored high-strength fiber**

(71) Applicant: Huang, Wen-Chang, Changhua County (TW)
(72) Inventor: Huang, Wen-Chang, Changhua County (TW)
(74) Representative: Becker Kurig Straus

(57) **Abstract**

A manufacturing method of a colored high-strength fiber has a preparation step, a dyeing step and a post-processing step. In the preparation step: a high-strength fiber substrate is surface-treated by solvent, and a surface of the high-strength fiber substrate is fractured, such that a surface-treated substrate is manufactured. In the dyeing step: the surface-treated substrate is plated, wherein multiple metal ions are combined with a surface of the surface-treated substrate, such that a dyed substrate is manufactured. In the post-processing step: the dyed substrate is surface-cleaned to remove remaining agents caused by the dyeing step, such that the colored high-strength fiber is manufactured.

## Description

### 1. Field of the Invention

The present invention relates to a fiber, and more particularly to a manufacturing method of a colored high-strength fiber and a colored high-strength fiber made by the manufacturing method.

### 2. Description of Related Art

Mostly, an appearance color of a high-strength fiber is a deep color, for example: the appearance color of a carbon fiber is black. The high-strength fiber is hard to be dyed since the dying is restricted by the original color and the material properties of the high-strength fiber.

To manufacture high-strength fibers of different appearance colors, masterbatches are added in the manufacturing process. However, the described conventional method is limited by the original color of the high-strength fiber, since the dyeing color of an aramid fiber is limited to colors such as blue, red, black or orange, and the manufacturing cost is high.

In addition, inorganic fiber, such as glass fiber or basalt fiber, can be dyed by masterbatches due to the surface recombination limit. Alternatively, the inorganic fiber is dyed by dyestuffs. However, the dyed color of the inorganic fiber may fade away easily due to remodeling process or high temperature.

The main objective of the present invention is to provide a manufacturing method of a colored high-strength fiber and a colored high-strength fiber to resolve the aforementioned problems.

The manufacturing method has a preparation step, a dyeing step and a post-processing step.

In the preparation step, a high-strength fiber substrate is surface-treated by a solvent, such that a surface of the high-strength fiber substrate is fractured and a surface-treated substrate is manufactured.

In the dyeing step, the surface-treated substrate is plated, wherein multiple metal ions are combined on a surface of the surface-treated substrate, such that a dyed substrate is manufactured.

In the post-processing step, the dyed substrate is surface-cleaned to remove remaining agents caused by the dyeing step, such that the colored high-strength fiber is manufactured.

The colored high-strength fiber made of the described manufacturing method has a fiber substrate and a colored layer electroplated on an outer side of the fiber substrate.

Other objectives, advantages and novel features of the present invention will become more apparent from the following detailed description when taken in conjunction with the accompanying drawings.

### IN THE DRAWINGS

Fig. 1 is a block diagram of a preferred embodiment adopting electroless plating of a manufacturing method of a colored high-strength fiber in accordance with the present invention;
Fig. 2 is a block diagram of another preferred embodiment adopting vacuum plating of a manufacturing method of a colored high-strength fiber in accordance with the present invention; and
Fig. 3 is an enlarged cross sectional side view of a colored high-strength fiber in accordance with the present invention.

Plating is regarded as an electro-deposition process, wherein multiple metal ions are attached to a surface of a fiber substrate to form a metal coating layer on the surface of the fiber substrate and to change a surface property of the finer substrate.

The present invention provides a method to dye a high-strength fiber substrate by plating since plating is used for adding a metallic gloss or a colored appearance to the fiber substrate, wherein the high-strength fiber substrate may be carbon fiber substrate, aramid fiber substrate or any other fiber substrate. In the present invention, "electroless plating" or "vacuum plating" is adopted for dyeing the high-strength fiber substrate.

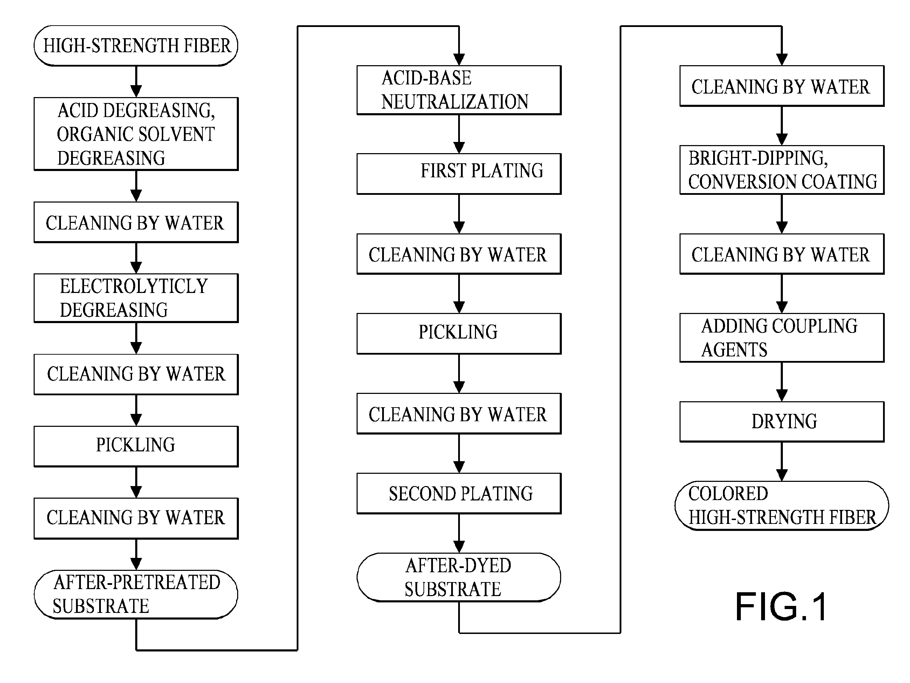

With reference to Fig. 1, a preferred embodiment of a manufacturing method of a colored high-strength fiber adopting the "electroless plating" in accordance with the present invention has a preparation step, a dyeing step, and a post-processing step.

### 1. The preparation step:

To begin with, a high-strength fiber substrate is placed in a first tube or a vacuum chamber to be acid-degreased and organic solvent degreased. The high-strength fiber substrate is cleaned by water to remove the remaining solvent caused by the acid degreasing and the organic solvent degreasing on a surface of the high-strength fiber substrate.

Then, the high-strength fiber substrate is electrolytically degreased, and then is cleaned by water to remove the remaining solvent caused by the electrolytic degreasing on the surface of the high-strength fiber substrate.

Furthermore, the high-strength fiber substrate is pickled in acid bath and is cleaned by water, such that a surface-treated substrate is manufactured. The surface-treated substrate is dyed easier than the fiber substrate since the coupling agent and the oil agent adhered on the fiber substrate are removed and a surface of the surface-treated substrate is fractured by pickling.

### 2. The dyeing step:

To begin with, the surface-treated substrate is placed in a second tube or the vacuum chamber to be acid-base neutralized to prevent the remaining solvent caused by the preparation step from affecting the following processes. After the acid-base neutralization, the surface-treated substrate is placed in a third tube or the vacuum chamber for a first plating. Dyeing color sources, such as metal ions, metal oxides, or chemicals agents, exist in the third tube or the vacuum chamber and are provided for ion-exchanging with the surface of the surface-treated substrate, and the surface of the surface-treated substrate can be dyed.

Then, the surface-treated substrate is cleaned by water to remove the remaining solvent caused by the dyeing process. The surface-treated substrate is further pickled in acid bath and is cleaned by water again.

Furthermore, the surface-treated substrate is subjected to a second plating so as to manufacture a dyed substrate. Preferably, the electrolytes of the first plating and the second plating are aqueous solutions. The electroless plating can generate a metal coating on the dyed substrate, such as nickel, cobalt, palladium, copper, gold, silver, or alloy of the described metals, so that the dyed substrate can display a desired color of the metal coating. A shade of the desired color can be controlled by adjusting the operating power of the first plating and the second plating to control the amount of the dyeing color sources combined with the surface-treated substrate.

### 3. The post-processing step:

To begin with, the dyed substrate is cleaned by water, is bright-dipped, is conversion coated, and then is cleaned by water again to remove the remaining solvent from a surface of the dyed substrate.

Then, coupling agents are added to combine with the surface of the dyed substrate and are dried, such that a colored high-strength fiber is manufactured.

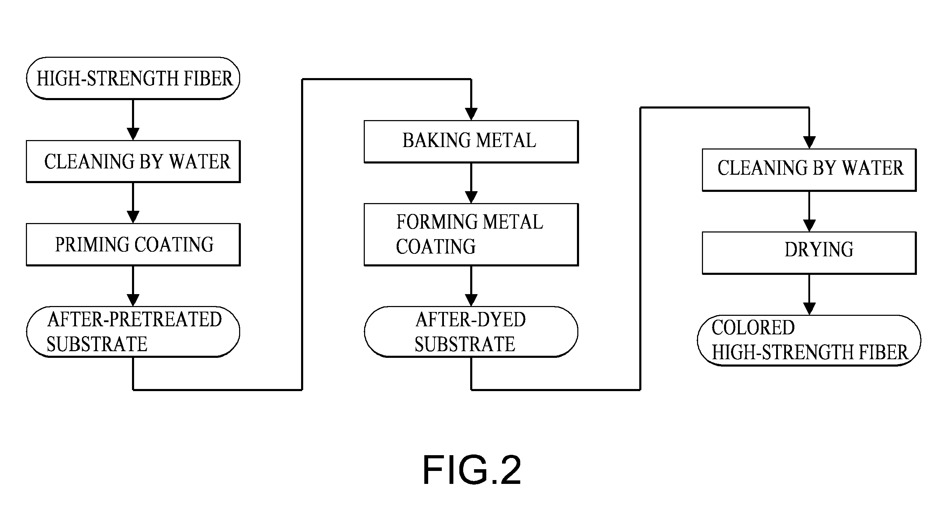

With reference to Fig. 2, a preferred embodiment of a manufacturing method of a colored high-strength fiber adopting the "vacuum plating" in accordance with the present invention has a preparation step, a dyeing step, and a post-processing step.

### 1. The preparation step:

A high-strength fiber substrate is cleaned and is priming coated, such that a surface-treated substrate is provided.

### 2. The dyeing step:

The surface-treated substrate and a metal are placed in a vacuum environment. The metal is baked to evaporate to form metal vapors. The metal vapors are combined with a surface of the surface-treated substrate to form a metal coating, such that a dyed substrate is manufactured.

### 3. The post-processing step:

The dyed substrate is cleaned by water and then is dried to manufacture a colored high-strength fiber.

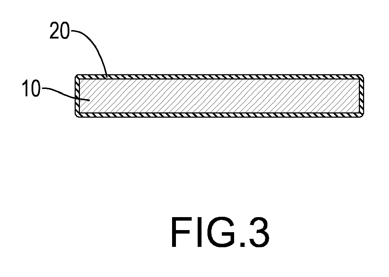

With reference to Fig. 3, the colored high-strength fiber dyed by the electroless plating or the vacuum plating has a fiber substrate 10 and a colored layer 20.

The fiber substrate 10 may be made of carbon fibers, glass fibers or aramid fibers. The colored layer 20 is electroplated on an outer side of the fiber substrate 10. A thickness of the colored layer 20 can be controlled by adjusting the operating power of the plating process.

From the above description, it is noted that the present invention has the following advantages:
1. The high-strength fiber acquires colorful appearance easily since the high-strength fiber is surface-dyeing by plating.
2. The dyeing cost can be reduced effectively since the masterbatches can be omitted in the plating process.
3. The metal ions are directly combined on the high-strength fiber to form the colored layer to keep the color of the high-strength fiber from fading.

Even though numerous characteristics and advantages of the present invention have been set forth in the foregoing description, together with details of the structure and function of the invention, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A manufacturing method of a colored high-strength fiber, **characterized in that** the manufacturing method comprises steps of:
a preparation step comprising: surface-treating a high-strength fiber substrate by a solvent, and fracturing a surface of the high-strength fiber substrate to form a surface-treated substrate;
a dyeing step comprising: plating the surface-treated substrate to form a dyed substrate, such that multiple metal ions are combined with a surface of the surface-treated substrate; and
a post-processing step comprising: surface-cleaning the dyed substrate to remove remaining agents caused by the dyeing step so as to form the colored high-strength fiber.

2. The manufacturing method of a colored high-strength fiber as claimed in claim 1, wherein
in the preparation step, surface-treating the high-strength fiber substrate comprises steps of: acid-degreasing, organic solvent degreasing, first cleaning by water, electrolytic degreasing, second cleaning by water, pickling and third cleaning by water, so as to obtain the surface-treated substrate;
in the dyeing step, plating the surface-treated substrate comprises steps of:
acid-base neutralization, first plating, first cleaning by water, pickling, second cleaning by water, and second plating the surface-treated substrate to obtain the dyed substrate, wherein the metal ions are combined with the surface of the surface-treated substrate when the first plating and the second plating are operating; and
in the post-processing step, surface-cleaning the dyed substrate comprises steps of: first cleaning by water, bright-dipping, conversion coating, second cleaning by water, adding coupling agents to combine with a surface of the dyed substrate, and drying the dyed substrate.

3. The manufacturing method of a colored high-strength fiber as claimed in claim 2, wherein in the dyeing step, electrolytes of the first plating and the second plating are aqueous solutions.

4. The manufacturing method of a colored high-strength fiber as claimed in claim 1, wherein
in the preparation step, surface-treating the high-strength fiber substrate comprises steps of cleaning and priming coating;
in the dyeing step, plating the surface-treated substrate comprises steps of: placing the surface-treated substrate and a metal in a vacuum environment and baking the metal to evaporate to form metal vapors to combine with the surface of the surface-treated substrate to form a metal coating; and
in the post-processing step, surface-cleaning the dyed substrate comprises steps of: cleaning by water and drying.

5. A colored high-strength fiber made of the manufacturing method as claimed in claim 1, **characterized in that** the colored high-strength fiber comprises:
a fiber substrate (10); and
a colored layer (20) electroplated on an outer side of the fiber substrate (10).

6. The colored high-strength fiber as claimed in claim 5, wherein the fiber substrate (10) is made of carbon fibers.

7. The colored high-strength fiber as claimed in claim 5, wherein the fiber substrate (10) is made of glass fibers.

8. The colored high-strength fiber as claimed in claim 5, wherein the fiber substrate (10) is made of aramid fibers.
